(19) Europäisches Patentamt
European Patent Office
Office européen des brevets

(11) **EP 1 094 381 A2**

# (12) EUROPEAN PATENT APPLICATION

(43) Date of publication:
**25.04.2001 Bulletin 2001/17**

(51) Int. Cl.[7]: **G06F 1/04**

(21) Application number: **00122695.0**

(22) Date of filing: **18.10.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **18.10.1999 JP 29566699**

(71) Applicant:
**NIPPON PRECISION CIRCUITS INC.**
**Tokyo (JP)**

(72) Inventor:
**Satoru, Miyabe,**
**c/o Nippon Precision Circuits Inc.**
**Tokyo (JP)**

(74) Representative:
**Grünecker, Kinkeldey,**
**Stockmair & Schwanhäusser**
**Anwaltssozietät**
**Maximilianstrasse 58**
**80538 München (DE)**

## (54) Self-modulated type clock generating circuit

(57) To restrain cycle-to-cycle jitter in a clock generator subjected to EMI measure, in a 2nd order PLL having a loop filter 7 including a first capacitor and a first resistor, a reduction in a comparison frequency is restrained by using a clock modulating circuit 2 controlled by a signal 16 provided by dividing an oscillation signal of a voltage control type oscillator 13 and recurrently controlling a divider 15, generation of high frequency noise is minimized by using a 1st order ΔΣ modulator 21 in the clock modulation circuit 2 and the system is constituted by a 3rd order PLL by using a second capacitor 3 having a capacitance value of about 1/10 or more of that of the first capacitor in parallel with the loop filter 7 to thereby restrain the intercycle jitter by effectively removing the high frequency noise.

Fig.1

EP 1 094 381 A2

**Description**

BACKGROUND OF THE INVENTION

FIELD OF THE INVENTION

The present invention relates to a clock generating circuit, particularly to a self-modulated type clock generating circuit spreading frequency spectrum of output clock.

DESCRIPTION OF THE RELATED ART

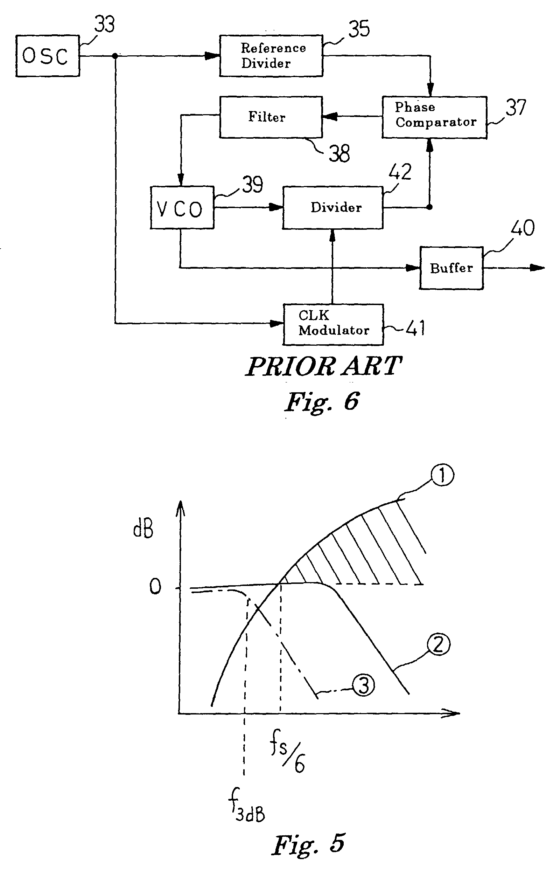

Currently, with regard to a clock generating circuit for generating high-speed clock used in a microprocessor and the like starting from CPU, there is provided a clock generating circuit reducing electromagnetic interference (EMI) to peripheral apparatus. Among them, there is a clock circuit disclosed in, for example, Japanese Patent Laid-Open No. 235862/1995. According thereto, as shown by Fig. 6, there is adopted a clock modulation system for controlling a divider 42 for dividing an oscillation signal of a voltage control type oscillator in PLL (Phase Locked Loop) 39 by using an outside reference signal from a quartz oscillation circuit 33. By applying modulation of a low frequency to clock, power of clock is not concentrated on a specific single frequency but is spread to a certain constant frequency band to thereby provide an EMI reduction effect. Further, in Fig. 6, numeral 35 designates a reference divider for dividing the reference signal of the quartz oscillation circuit 33, numeral 37 designates a phase frequency comparator for comparing phases of output of the reference divider 35 and output of the divider 42, numeral 38 designates a filter, numeral 41 designates a clock modulation circuit for controlling the divider 42 and numeral 40 designates a buffer for outputting the clock to outside.

Generally, in PLL technology, there is constructed a mechanism in which an external reference signal and an oscillation signal of an internal voltage control type oscillator are respectively divided to set to a common frequency referred to as a comparison frequency and an error signal provided by comparing phases and frequencies of two divider signals by the frequency is made to constitute a frequency correction signal of the voltage control type oscillator via a low pass filter referred to as a loop filter to thereby maintain the voltage control type oscillator continuously at a predetermined frequency and provide high-speed clock. The voltage control type oscillator must continue oscillating without being corrected from outside during a time period from phase frequency comparison at a certain instance to successive phase frequency comparison. The longer the state continues, the wider the deviation from the reference becomes. Therefore, the higher the comparison frequency, that is, the faster the correction of the voltage control type oscillator is carried out, the smaller the error and the smaller the correction signal and conversely, the lower the comparison frequency, the larger the correction signal.

Further, it is known that the main cause of an instantaneous jump phenomenon of clock frequency which is referred to as cycle-to-cycle jitter of clock, is a remaining component of the error signal after passing through the loop filter. Therefore, in order to restrain the cycle-to-cycle jitter, it is important to increase the comparison frequency and apply correction before the error is increased.

However, according to the above-described conventional clock generating circuit, the external reference signal is used as internal clock for operating the clock modulation circuit. According to a clock generator for generating high-speed clock, the frequency of the reference signal is relatively low and a number of clocks generated until successive phase frequency comparison is small. Therefore, in order to ensure a number of clocks sufficient for finishing the processing by the clock modulation circuit until successive phase frequency comparison, the comparison frequency must be reduced. As a result, there poses a problem in which the error signal is increased and the cycle-to-cycle jitter is increased.

Further, there has been reported a clock generator for executing fraction division which cannot be dealt with by a divider in PLL by controlling PLL for communication by using a $\Delta\Sigma$ modulator having an order of second order or higher to thereby generate fixed clock having no modulation. In this case, in order to reproduce a direct current signal having high resolution by the $\Delta\Sigma$ modulator, the $\Delta\Sigma$ modulator having the order of second order or higher having noise random performance must be used. As is well known, the $\Delta\Sigma$ modulator is provided with a noise shaping effect and is operated to reduce noise at 1/6 of an operational frequency or lower and increase noise at a frequency higher than 1/6 of the operational frequency, the higher the order of the $\Delta\Sigma$ modulator, the more increased is noise of high frequency, so-to-speak remaining quantization noise and accordingly, by applying the noise to PLL, the cycle-to-cycle jitter is caused to increase.

Further, there poses a problem, mentioned below, in applying the clock modulation system to general 2nd order PLL. In the 2nd order PLL system having a loop filter constituted by series connection of a first capacitor and a first resistor to the ground, it is the common practice that an additional capacitor having a capacitance value Cadd sufficiently smaller than a capacitance value CL of the first capacitor (for example, one fiftieth) is used to connect in parallel with the loop filter. Also in this case, the system is approximately dealt with as the 2nd order PLL system. Here, it is regarded as an absolute condition for guaranteeing the stability of the system that the additional capacitor is sufficiently smaller than the first capacitor. That is, the maximum value of phase margin constituting an index of the stability of the 2nd order PLL which the system can take, is represented as follows by a ratio of the first capacitor to the additional capacitor (notation RL designates a resistance value of the first resistor).

$$\text{Phase margin} = |\tan^{-1}(X/\gamma) - \tan^{-1}(x)| \qquad (1)$$

where $\gamma \equiv (CL/Cadd)$, $X \equiv \omega\tau1$, $\tau1 \equiv RL \cdot CL$.

Now, consider a case in which the ratio of the first capacitor and the additional capacitor is 1. Then, maximum possible phase margin becomes zero and such a system cannot be present stably. Further, band $\omega3dB$ of the 2nd order PLL approximate system using the additional capacitor is represented as follows.

$$\omega3dB = \omega n \cdot \sqrt{(-(2\zeta^2 - 1) + \sqrt{((2\zeta^2 - 1)^2 + 1)})} \qquad (2)$$

where $\omega n = \sqrt{(Ko \cdot Ip/2\pi NCadd)}$, $\zeta = 1/2\omega n\tau2$, notation Ko designates a gain of the voltage control type oscillator, notation Ip designates a current value of a charge pump, notation N designates a number of divisions of the divider, and $\tau2 \equiv RL \cdot Cadd$. These notations are similar in the following description.

Almost all of various parameters determining Equation (2) are normally determined by a desired output clock frequency of the clock generating circuit, and Cadd and RL remain as adjustable parameters. Cadd can change $\omega n$ and $\zeta$ and RL can only change $\zeta$. Therefore, the band $\omega3dB$ can be adjusted by changing $\omega n$ by Cadd while maintaining constant $\zeta$ by adjusting RL and maintaining constant inside of root sign of Equation (2) thereby. However, as described above, Cadd is permitted to change relative to CL only in a sufficiently small range and accordingly, even when the $\Delta\Sigma$ modulation method is intended to apply to the 2nd order PLL, the PLL band sufficient for removing high-frequency noise generated by the $\Delta\Sigma$ modulator cannot be ensured.

SUMMARY OF THE INVENTION

In a 2nd order PLL having a loop filter constituted by series connection of a first capacitor and a first resistor to the ground, by using a clock modulating circuit controlled by a signal provided by dividing an oscillation signal of a high-speed voltage control type oscillator in PLL by a divider in PLL and recurrently controlling the divider, a comparison frequency is maintained high by guaranteeing to provide a number of clocks sufficient for the clock modulating circuit to finish processing during a time period from a certain instance of phase frequency comparison to successive phase frequency comparison. Thereby, generation of an error signal causing cycle-to-cycle jitter is minimized. Generation of high frequency noise causing the cycle-to-cycle jitter is minimized by using a 1st order $\Delta\Sigma$ modulator as the clock modulation circuit. Further, the system is constituted by a 3rd order PLL by using a second capacitor having a capacitance value of about 1/10 or more of that of the first capacitor in parallel with the loop filter to thereby effectively remove high frequency noise generated by the $\Delta\Sigma$ modulator.

According to an aspect of the invention, there is provided a self-modulated type clock generating circuit comprising a 2nd order PLL including a voltage control type oscillator for generating an external clock signal having a frequency in accordance with an output of a loop filter, a divider for dividing an output of the voltage control type oscillator, converting means for converting an output reference signal into a comparison frequency signal having a predetermined frequency, a phase frequency comparator for comparing phases and frequencies of an output signal of the divider and the comparison frequency signal and generating an error signal in correspondence with a phase frequency error, a charge pump for generating an electric charge amount in accordance with the error signal and the loop filter comprising a first capacitor and a first resistor connected in series between an output terminal of the charge pump and a specific potential, a clock modulation circuit including a 1st order $\Delta\Sigma$ modulator controlled based on the output clock signal and including a 1st order $\Delta\Sigma$ modulator for recurrently controlling a number of divisions of the divider and spreading a frequency of the output clock, and a second capacitor connected to the 2nd order PLL in order to remove remaining quantization noise provided to the 2nd order PLL by the $\Delta\Sigma$ modulator.

Further, it is preferable that the second capacitor is provided with a capacitance value of 1/10 or more of a capacitance value of the first capacitor.

Further, it is also preferable that the self-modulated type clock generating circuit can be switched to a fixed clock generating circuit as needed by controlling an output value of the $\Delta\Sigma$ modulator.

BRIEF DESCRIPTION OF THE DRAWINGS

Fig. 1 is an explanatory view for explaining constitution of a self-modulated type clock generating circuit according to an embodiment of the invention;
Figs. 2A, 2B, 2(22) and 2(12) are waveform diagrams for explaining operation of essential portions of a clock modulation circuit in Fig. 1;
Fig. 3 is an explanatory view for explaining a characteristic of essential portions of a ΔΣ modulator of Fig. 1;
Fig. 4 is an explanatory view for explaining a characteristic of essential portions of PLL of Fig. 1;
Fig. 5 is an explanatory view for explaining a characteristic of essential portions of PLL of Fig. 1; and
Fig. 6 is an explanatory view for explaining constitution of a conventional clock generating circuit.

DETAILED DESCRIPTION OF THE PREFERRED EMBODIMENTS

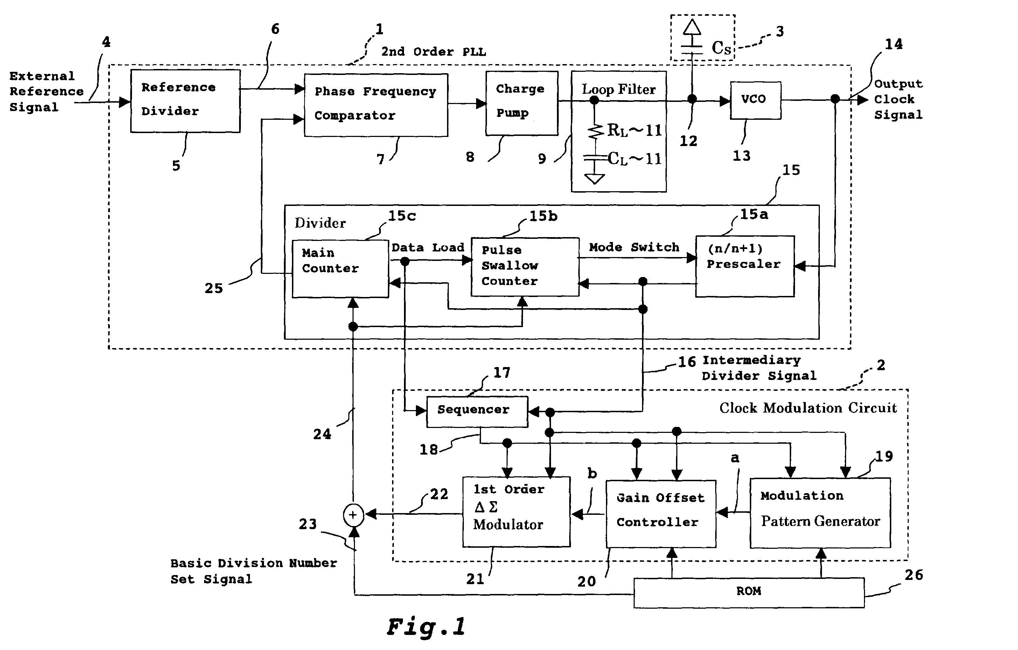

A detailed explanation will be given of embodiments of the invention in reference to the drawings as follows. Fig. 1 is an explanatory view for explaining an example of a clock generating circuit according to the invention. In Fig. 1, numeral 1 designates a 2nd order PLL system including a first capacitor 10, numeral 2 designates a clock modulating circuit and numeral 3 designates a second capacitor.

The 2nd order PLL system 1 is constituted by the following elements. Numeral 4 designates an external reference signal and numeral 5 designates a reference divider (a frequency multiplier may be used as necessary) for dividing the reference signal and generating a reference divider signal 6 as a comparison frequency signal having a predetermined comparison frequency. Numeral 7 designates a phase frequency comparator for comparing phases and frequencies of the reference divider signal 6 and a divider signal of a divider, mentioned later, and generating an error signal in correspondence with a phase frequency error. Numeral 8 designates a charge pump for generating an electric charge amount in correspondence with the error signal. Numeral 9 designates a loop filter constituted by the first capacitor 10 and a first resistor 11 and numeral 12 designates an output terminal of the loop filter. Further, the capacitor 10 and the resistor 11 included in the loop filter 9 are connected in series with each other and connected to the ground or a power source terminal. The second capacitor 3 is connected between the output terminal 12 of the loop filter and the ground or a power source terminal. Further, the loop filter 9 may be added with an additional resistor or an additional capacitor. Further, the loop filter 9 may be constituted to be active. In this case, the first capacitor 10 and the first resistor 11 are connected in series with each other and connected to virtual ground or virtual bias power source and the second capacitor 3 is also connected to the virtual ground or the virtual bias power source. Numeral 13 designates a voltage control type oscillator for generating an output clock signal 14 having a frequency in accordance with an output signal from the output terminal 12 of the loop filter. Numeral 15 designates a divider for dividing the output clock signal 14 and is constituted by an n/(n+1) prescaler 15a generating an intermediary divider signal 16, a pulse swallow counter 15b and a main counter 15c. The n/(n+1) prescaler 15a can deal with various number of divisions by switching the number of divisions to "n" or (n+1) in accordance with a mode switch signal. The main counter 15c is a down counter for counting down a set value, that is, the number of divisions and is constituted to generate a data load signal after finishing one set of counting operation and repeat down counting again by loading the set value. Further, in the case of a divider which does not use a prescaler, an intermediary divider signal 16 is constituted by an output from a pertinent division stage of the divider.

The clock modulating circuit 2 is constituted by a sequencer 17, a modulation pattern generator 19 receiving a timing signal 18 from the sequencer 17, a gain offset controller 20 and a 1st order ΔΣ modulator 21. Further, an output signal 22 from the ΔΣ modulator is added to a basic division number set signal 23 to thereby constitute an added signal 24 and is used as a set value of the divider 15. That is, a basic division number N designated by the basic division number set signal 23 is added with ΔN designated by the output signal 22 as a modulation value. The main counter 15c is loaded with the added signal 24 as a set value, counts down the division number indicated by the set value and thereby the divider 15 generates a divider signal 25 by dividing the output clock signal 14. Further, the basic frequency set signal 23 is read from ROM 26 and clock modulation pattern, gain and offset are provided to ROM 26 as data and generated by simple processing to thereby facilitate later adjustment.

Next, with regard to operation of the example, an explanation will firstly be given of basic PLL operation. The external reference signal 4 is divided by the reference divider 5 and is converted into the reference divider output signal 6. The reference divider signal 6 is inputted to the phase frequency comparator 7 along with the divider signal 25 to thereby detect a phase frequency error between the reference divider signal 6 and the divider signal 25. An error signal constituting the output from the phase frequency comparator 7 is transmitted to the charge pump 8, converted into an electric charge amount in proportion to the phase frequency error and is transmitted to the loop filter 9. As a result, the output signal from the loop filter output terminal 12 is changed in accordance with the phase frequency error and changes the voltage control type oscillator output 14 in a direction of reducing the phase frequency error. The voltage control type oscillator output 14 adjusted in this way is inputted to the divider 15 and the divider signal 25 is compared with the reference divider output signal 6 to thereby adjust the phase frequency error and by repeating the above-described series of operation, the output signal 14 from the voltage control type oscillator can be maintained continuously at a certain phase of a certain frequency. At this occasion, both of the reference divider signal 6 and the divider signal 25 constitute a signal having a frequency referred to as a comparison frequency.

Next, an explanation will be given of a relationship between the divider 15 and the clock modulation circuit 2.

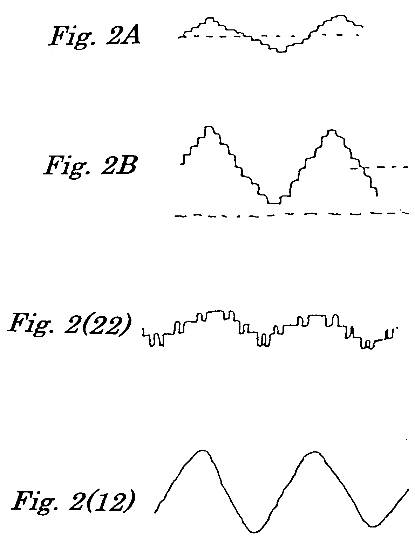

When the divider 15 has finished one set of down counting operation, the divider 15 updates setting of the number of divisions for entering a successive one set of down counting operation. The divider 15 transmits the divided intermediary output signal 16 from the prescaler 15a to the sequencer 17. The sequencer 17 generates the timing signal 18 necessary for the clock modulation circuit 2 by using the divided intermediary output signal 16. The clock modulating circuit 2 is provided with the $\Delta\Sigma$ modulator 21 at its output stage and adds quantization noise mainly of high frequency to a predetermined modulation digital signal produced by the clock modulation pattern generator 19 and the gain offset controller 20 to thereby reduce a number of bits of the modulation digital signal. For example, a digital triangular wave shown by Fig. 2A is outputted from the clock modulation pattern generator 19, the digital triangular wave signal is provided with gain and offset as shown by Fig. 2B by the gain offset controller 20 and thereafter modulated to the output signal 22 which is a digital signal having a number of quantization steps smaller than that shown by (22) of Fig. 2 by being subjected to $\Delta\Sigma$ modulation by the $\Delta\Sigma$ modulator 21. The output signal 22 is added with the basic division number set signal 23 and the divider 15 sets the number of divisions based on the added signal 24. The above-described series of operation is carried out recurrently with respect to the divider 15. Thereby, very small fluctuation can be given to the basic division number set signal 23 with respect to the divider 15. That is, fluctuation of $\pm 1.5$ % or 0.5 % for the basic division number which cannot be produced since fraction division cannot be executed by the divider 15 owing to a deficiency in the number of bits, is realized by providing the basic division number set signal 23 with the modulation data B in a form rounded to a small bit number (output signal 22) by using quantization noise out of band. Thereby, as shown by (12) of Fig. 2, a signal at the terminal 12 is slightly fluctuated as shown by (12) of Fig. 2 and the frequency of the output clock signal is spread.

Further, by pertinently adjusting the divided intermediary output signal 16, the timing signal 18 having a sufficient period necessary for the clock modulation circuit 2 can be generated. Therefore, there is no need of reducing the comparison frequency for the time period required for generating the timing signal of the clock modulation circuit 2 and the EMI reduction can be realized by the clock modulation effect while avoiding the reduction in the comparison frequency causing cycle-to-cycle jitter.

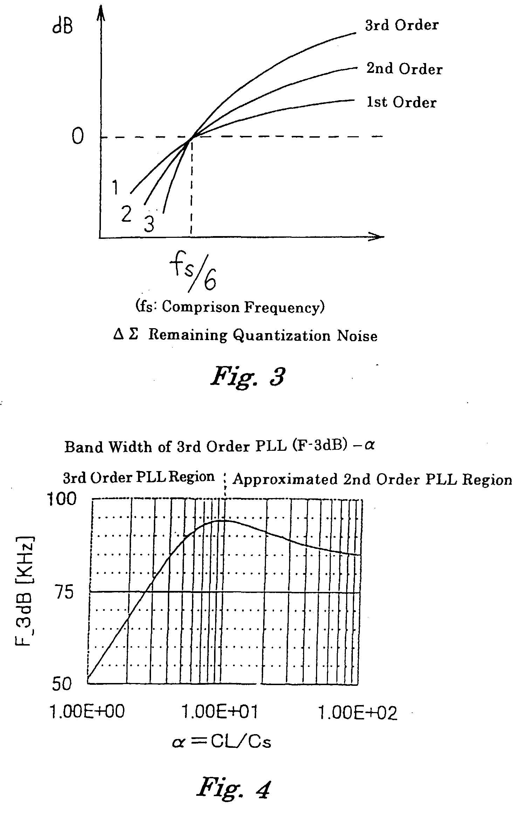

Further, the $\Delta\Sigma$ modulator 21 used in the clock modulation circuit 2 is used with the purpose of intentionally giving fluctuation to the clock frequency of the output clock signal 14 and accordingly, high resolution is not required different from the case of carrying out direct current control and therefore, the order can be the first order. Further, by positively constituting the order by the first order, as shown by Fig. 3, quantization noise at high frequency is smaller than that of a second or a third $\Delta\Sigma$ modulator and accordingly, generation of the quantization noise having high frequency causing cycle-to-cycle jitter can be minimized. The quantization noise is separated to a frequency band higher than the modulation signal band and accordingly, the quantization noise can be removed by properly adjusting PLL as mentioned below.

Next, a description will be given of the second capacitor 3 (capacitance value Cs) and an explanation will be given of that the second capacitor 3 according to the invention is effective to remove high-frequency noise generated at the 1st order $\Delta\Sigma$ modulator 21. When Cs is about 1/10 or more of the capacitance value CL of the first capacitor 10, the PLL system including the second capacitor 3 cannot be approximated to the 2nd order system but must be dealt with as a 3rd order system and in this sense, Cs must be understood as a parameter essentially different from the capacitance value Cadd which is sufficiently smaller than CL. Phase margin of the 3rd order PLL is shown by the following equation.

$$\text{Phase margin} = |\tan^{-1}(X/(\alpha+1)) - \tan^{-1}(x)| \tag{3}$$

where $\alpha \equiv (CL/Cs)$, $X \equiv \omega\tau 1$, $\tau 1 \equiv RL \cdot CL$.

As is apparent from Equation (3), it is known that in the case of the third order PLL, even when Cs=CL , the maximum phase margin does not become zero and the system is not necessarily unstable. As mentioned later, it can be said that the stability of a system necessary for a fixed clock generator and the stability of a system necessary for a modulation type clock generator are not necessarily to the same degree but the latter is sufficiently stable even in the case in which the above equation is put with Cs=CL .

Now, band $\omega$3dB of the 3rd order PLL is shown by the following equation.

$$\omega 3\text{dB} = \sqrt{(2\sqrt{(-p)} \times \cos((1/3) \cdot \cos^{-1}(-q/(2\sqrt{(-p^3)}))) - (a/3))} \tag{4}$$

where $p \equiv -(a^3/9) + (b/3)$, $q \equiv (2a^3/27) - (ab/3) + c$, further, $a \equiv (\alpha+1)(N(\alpha+1) - 2\tau 1^2 A)/(\tau 1^2 N)$, $b \equiv -(\alpha+1)^2 A(A\tau 1^2 + 2N)/(\tau 1^2 N^2)$, $C \equiv -(\alpha+1)^2 A^2/(\tau 1^2 N^2)$, $A \equiv Ko \cdot Ip/(2\pi CL) \times (\alpha/(\alpha+1))$.

Fig. 4 shows an example of a band constituted in a graph by giving typical design values to Equation (4). As is apparent from Fig. 4, in a region having a large ratio of CL/Cs, that is, a region which can be approximated to the 2nd order PLL since Cs is sufficiently smaller than CL, there is no capability of adjusting the band in Cs. Meanwhile, it is known that in a region having a small ratio of CL/Cs, that is, in a region in which Cs is about 1/10 or more of CL, Cs is operated to adjust the band. Therefore, by using the second capacitor 3 having the capacitance value Cs of about 1/10 of CL, band adjustment necessary for removing the high frequency noise generated in the 1st order ΔΣ modulator can be carried out. A specific description will be given in reference to Fig. 5. A noise characteristic of the 1st order ΔΣ modulator is shown in of Fig. 5, a characteristic of PLL before adjustment, that is, the 2nd order PLL is shown in and a characteristic of PLL after adjustment, that is, the 3rd order PLL is shown in . As shown in Fig. 5, a noise component at high frequency of the 1st order ΔΣ modulator which cannot be removed by the 2nd order PLL is removed by setting PLL band f3dB to 1/6 or smaller of the comparison frequency fs by adjusting Cs.

Next, a description will be given of the stability in the case in which clock modulation is applied to the 3rd order PLL. In a clock generator in which restraint of cycle-to-cycle jitter is regarded as important, there poses no problem in fluctuation of the clock frequency at low frequency referred to as long term jitter. This enables the clock modulation by low frequency. Meanwhile, fluctuation at low frequency is generated in PLL output by a reduction in phase margin in the 3rd order PLL and remaining of a component having a comparatively low inner noise of PLL since a negative feedback region is narrowed by narrow band formation. However, the fluctuation does not cause cycle-to-cycle jitter which is an instantaneous frequency jump. Further, such a low fluctuation component is smaller than the clock modulation signal intentionally applied and does not deteriorate the clock characteristic of the modulation type clock generator.

Further, similar reasoning is established with regard to a fixed clock generator in which only cycle-to-cycle jitter is regarded as important and accordingly, the above described 3rd order PLL system can be used as a fixed clock generator when the 1st order ΔΣ modulator 21 is stopped or brought into a zero output state.

Further, the fixed clock generator and the modulation type clock generator can be realized only by switching control of the output value of the 1st order ΔΣ modulator without switching constants in PLL at all.

According to the invention, the clock generating circuit is constituted by combining the 2nd order PLL having the loop filter constituted by series connection of the first capacitor and the first resistor to specific potential (ground or power source, or virtual ground or virtual bias power source), the 1st order ΔΣ modulator controlled by the divider signal provided by dividing the oscillation signal of the voltage control type oscillator in the PLL by the divider in the PLL and controlling the divider recurrently and the second capacitor having the capacitance value of about 1/10 or more of that of the first capacitor and accordingly, in addition to the reduction in the electromagnetic interference (EMI), the cycle-to-cycle jitter can be reduced.

## Claims

1.    A self-modulated type clock generating circuit comprising:

    a 2nd order PLL including a voltage control type oscillator for generating an output clock signal having a frequency in accordance with an output of a loop filter, a divider for dividing an output of the voltage control type oscillator, converting means for converting an external reference signal into a comparison frequency signal having a predetermined frequency, a phase frequency comparator for comparing phases and frequencies of an output signal of the divider and the comparison frequency signal and generating an error signal in correspondence with a phase frequency error, a charge pump for generating an electric charge amount in accordance with the error signal and the loop filter comprising a first capacitor and a first resistor connected in series between an output terminal of the charge pump and a specific potential;
    a clock modulation circuit being controlled based on the output clock signal, and including a 1st order ΔΣ modulator for recurrently controlling a number of divisions of the divider and diffusing a frequency of the output clock; and
    a second capacitor connected to the 2nd order PLL in order to remove remaining quantization noise provided to the 2nd order PLL by the ΔΣ modulator.

2.    The self-modulated type clock generating circuit according to Claim 1:
    wherein the second capacitor is provided with a capacitance value of 1/10 or more of a capacitance value of the first capacitor.

3.    The self-modulated type clock generating circuit according to Claim 1:

wherein said self-modulated type clock generating circuit can be switched to a fixed clock generating circuit as needed by controlling an output value of the ΔΣ modulator.

*Fig.1*

*Fig. 2A*

*Fig. 2B*

*Fig. 2(22)*

*Fig. 2(12)*

dB

0

1
2 3

$f_s/6$

(fs: Comprison Frequency)

Δ Σ Remaining Quantization Noise

*Fig. 3*

Band Width of 3rd Order PLL (F-3dB) − α

3rd Order PLL Region : Approximated 2nd Order PLL Region

100

F_3dB [KHz]

75

50

1.00E+00          1.00E+01          1.00E+02

α = CL/Cs

*Fig. 4*

*PRIOR ART*

*Fig. 6*

*Fig. 5*